# EUROPEAN PATENT APPLICATION

(11) **EP 0 545 364 A1**
(43) Date of publication of application: **09.06.1993**
(21) Application number: 92120494.7
(22) Date of filing: 01.12.1992
(51) Int. Cl.: H03K 19/0944, H03K 19/003

(54) **BICMOS output buffer circuit with CMOS data paths and bipolar current amplification**

(30) Priority: 06.12.1991 US 804105
(71) Applicant: NATIONAL SEMICONDUCTOR CORPORATION, Santa Clara, California 95052-8090 (US)
(72) Inventor: Ohannes, James R., Portland, Maine 04101 (US); Yarbrough Roy L., Hiram, Maine 04041 (US); Clukey, Stephen W., South Portland, Maine 04106 (US); Keown, Susan M., Portland, Maine 04102 (US); Haacke, E. David, Westbrook, Maine 04092 (US); Ward, Michael G., Saco, Maine 04072 (US)
(74) Representative: Sparing Röhl Henseler Patentanwälte

(57) **Abstract**

A BICMOS output buffer circuit incorporating CMOS transistors and bipolar transistors is coupled between high and low potential power rails (V_{CCI},GNDO) for delivering output signals of high and low potential levels at an output (V_{OUT}). A bipolar output stage is formed by relatively large current conducting bipolar output pullup (Q24,Q22) and pulldown (Q44) transistors coupled to the output (V_{OUT}) and provides relatively low output impedance. Data signal paths coupled to the output stage are defined by CMOS transistors including CMOS input stages coupled to the input (V_{IN}). Small current conducting CMOS transistors afford relatively high input impedance. The bipolar output stage provides current amplification of data signals from the CMOS transistor defined data signal paths. The P channel and N channel CMOS transistors of a pullup predriver input stage (Q15,Q14) are constructed with the P/N ratio of channel width dimensions skewed relative to the P/N ratio of channel width dimensions of respective P channel and N channel CMOS transistors of the pulldown predriver input stage (Q11,Q10) for skewing the input threshold voltage levels of the respective pullup and pulldown predriver input stages. The skewed construction minimizes simultaneous conduction between the bipolar output pullup transistor (Q22) and pulldown transistor (Q24). A pulldown driver stage (Q60,Q9A) coupled to a base node of the bipolar output pulldown transistor (Q44), includes a CMOS phase splitting pulldown driver transistor (Q60) and a fast CMOS Miller Killer (MK) transistor (Q9A) which functions as both DCMK and ACMK transistor.

## Description

This invention is related to the following U.S. patent Application: Alan C. Rogers U.S. Patent Application Serial No. 508,283 filed April 9, 1990 for TTL TO CMOS TRANSLATING CIRCUITS WITHOUT STATIC CURRENT introduces bipolar transistors into CMOS output buffer circuits and latch circuits as level shifting devices on the pullup side of input and output stages;
European patent application filed concurrently introduces CMOS phase splitter transistors into essentially bipolar TTL output buffer circuits;
The US patent application Serial No. filed concurrently for BICMOS TRISTATE OUTPUT BUFFER CIRCUIT WITH STATE DEPENDENT OUTPUT PULLUP DISCHARGE PATHS;
and European patent application filed concurrently all describe improvements upon the present circuit. Michael G. Ward U.S. Patent Application Serial No. 684,043 filed April 11, 1991 for HIGH SPEED PASSGATE, LATCH, AND FLIP-FLOP CIRCUITS, describes a BICMOS passgate circuit with transient enhancement of CMOS passgate and latch transistors and stages using bipolar transistors. The present invention is also related to the James R. Ohannes et al. U.S. Patent Application Serial No. filed concurrently for BICMOS INVERTER WITH BIPOLAR ENHANCED CURRENT DRIVE & ANTISIMULTANEOUS CONDUCTION in which the basic CMOS circuit building block, the CMOS inverter stage is enhanced with parallel bipolar transistors. The enhanced BICMOS inverter stage may be applied in BICMOS circuits at input, output, and internal stages.

### Technical Field

This invention relates to BICMOS logic circuits and gates, multi-stage buffer circuits including input buffer circuits and output buffer circuits, and generally to BICMOS circuits incorporating both CMOS transistors and bipolar transistors. The invention is applicable to BICMOS TTL output buffer circuits and to TTL to CMOS and CMOS to TTL translating buffer circuits.

### Background Art

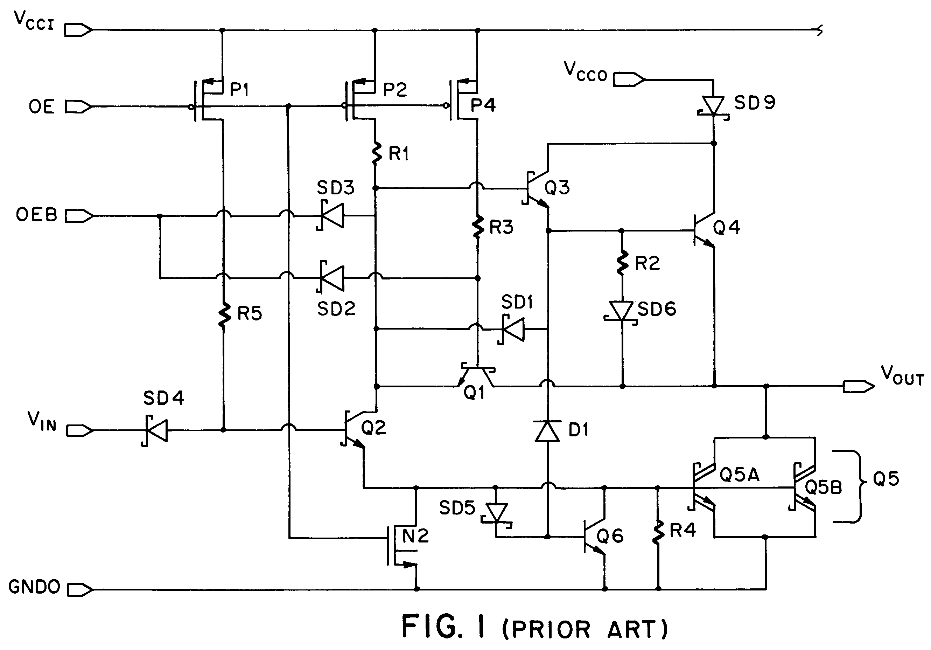

A conventional tristate BICMOS TTL output buffer circuit is illustrated in FIG. 1. The example of FIG. 1 is an inverting output buffer circuit delivering low and high potential level output signals at the output V_{OUT} in response to high and low potential level data signals at the input V_{IN}. The output pullup and pulldown transistors are bipolar transistors. The pullup Darlington transistor pair Q3,Q4 sources current to the output V_{OUT} from an output high potential power rail V_{CCO} through Schottky diode SD9. The pulldown transistor Q5 provided by high current drive parallel transistor elements Q5A,Q5B sinks current from the output V_{OUT} to the low potential power rail GNDO. The bipolar phase splitter transistor Q2 controls the conducting states of the respective pullup and pulldown transistors in opposite phase in response to data signals at the input V_{IN}. The input V_{IN} is coupled to the base node of phase splitter transistor Q2 through input Schottky diode SD4.

With a high potential level signal at the input V_{IN} phase splitter transistor Q2 is conducting and turns on the pulldown transistor Q5. Discharge current from the output V_{OUT} assists in the turn on of the pulldown transistor Q5 through an accelerating feedback circuit provided by bipolar feedback transistor Q1 having a base node coupled to the input high potential power rail V_{CCI} through resistor R3. The input and output high potential power rails V_{CCI}, V_{CC0} may be relatively isolated from each other for noise reduction by a split lead leadframe or by separate supply rails. The phase splitter transistor Q2 is coupled to the input high potential power rail V_{CCI} through collector resistor R1 and base resistor R5. It discharges the base and turns off pullup transistor Q3. Alternative discharge paths through Schottky diode SD1 and through resistor R2 and Schottky diode SD6 accelerate turn off of pullup transistor Q4.

With a low potential level data signal at the input V_{IN} the phase splitter transistor Q2 turns off and the base of the pulldown transistor Q5 is discharged through resistor R4. To prevent turn on of pulldown transistor Q5 by capacitive feedback Miller current during transition from high to low potential level at the output V_{OUT}, an AC Miller killer circuit (ACMK) Q6,SD5,D1,SD1 is coupled to the base node of pulldown transistor elements Q5A,Q5B. The ACMK circuit discharges parasitic base drive feedback Miller current at the base of bipolar pulldown transistor Q5 to the low potential power rail GNDO.

A tristate circuit for implementing an inactive high impedance tristate condition at the output V_{OUT} is provided by CMOS transistors P1,P2,P4,N2 having control gate nodes coupled to tristate enable input OE. For the active bistate mode of operation at the output V_{OUT}, a low potential level OE signal turns on the tristate PMOS transistors P1,P2,P4. The tristate PMOS transistors are transparent, coupling the input high potential power rail V_{CCI} to the input, phase splitter and feedback circuits. Tristate NMOS transistor N2 is also coupled to the tristate enable input OE. With the low potential level OE signal, tristate NMOS transistor N2 is non-conducting blocking the path to low potential power rail GNDO from the base node of output pulldown transistor Q5 for active operation in the bistate mode.

The tristate enable circuitry also incorporates Schottky diodes SD2,SD3 coupled between the respective base nodes of pullup transistor Q3 and feedback transistor Q1, and a complementary tristate enable input OEB. With a high potential level OEB signal, this path is blocked for bistate operation at the output V_{OUT} in the active mode.

The tristate circuit disables the output V_{OUT} in a high impedance third state with tristate enable low potential OE signal and high potential OEB signal. The high potential level OE signal turns off tristate PMOS transistors P1,P2, and P4 isolating the input, phase splitter and feedback circuits from the high potential power rail V_{CCI}. Tristate NMOS transistor N2 turns on and disables the bipolar pulldown transistor Q5. The low potential level OEB signal disables the bipolar pullup transistors Q3,Q4 as well as the bipolar feedback transistor Q1 through Schottky diode paths SD2,SD3.

A disadvantage of the tristate BICMOS TTL output buffer circuit of FIG. 1 is the high power dissipation during active operation in the bistate mode. With a low potential level data signal at the input V_{IN} holding off the phase splitter transistor Q2, a steady state or quiescent input current I_{CC} continues to flow from the high potential power rail V_{CCI} through tristate transistor P1, resistor R5 and input diode SD4 to the input node V_{IN}. This quiescent current continues for the duration of a low potential level signal at the input V_{IN}.

It is also noted in the conventional BICMOS TTL output buffer circuit of FIG. 1 that CMOS transistors are introduced in the essentially bipolar TTL output buffer circuit only in the tristate enable circuit. The CMOS transistors P1,P2,P4,N2 are limited to the power circuit paths for connecting or disconnecting the bipolar output buffer circuit elements with respect to the high and low potential power rails. The tristate CMOS transistors P1,P2,P4,N2 are controlled only by power signals at the tristate enable circuit input OE, and are not incorporated into the data path.

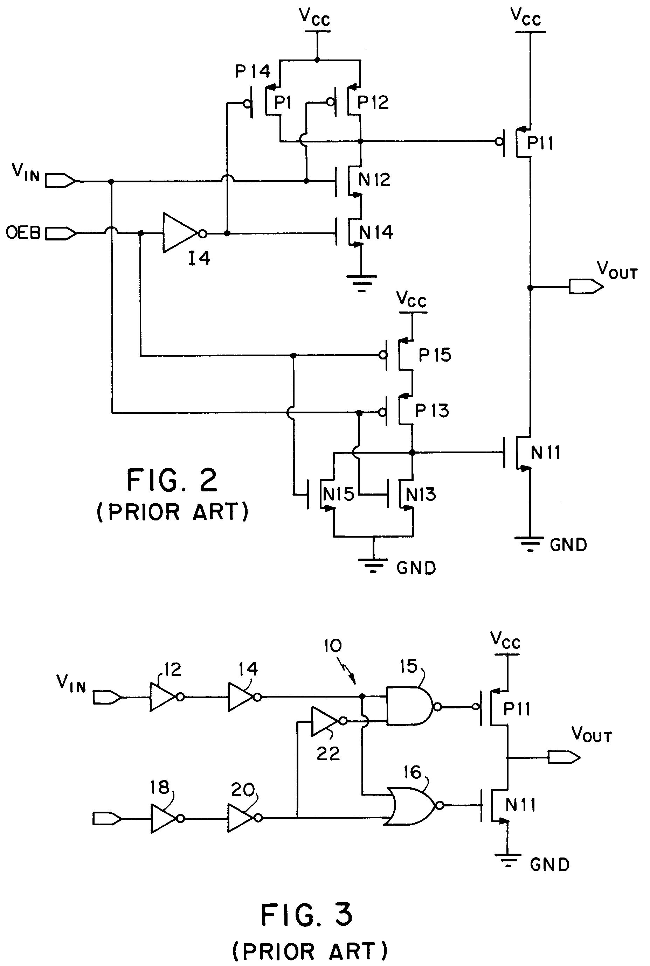

A conventional CMOS output buffer circuit having an output V_{OUT} for delivering output signals of high and low potential levels in response to data signals at the input V_{IN} is illustrated in FIG. 2. An output pullup transistor P11 sources current to the output V_{OUT} from a high potential rail V_{CC}. An output pulldown transistor N11 sinks current from the output V_{OUT} to a low potential rail GND. A pullup driver circuit in the form of inverter stage P12, N12 is coupled to a gate node of the output pullup transistor P11 for controlling the conducting state of P11 in response to data signals at the input V_{IN}. A pulldown driver circuit in the form of inverter stage P13, N13 is coupled to a gate node of the output pulldown transistor N11 for controlling the conducting state of transistor N11 in response to data signals at the input V_{IN}.

The CMOS output buffer circuit of FIG. 2 is a tristate output circuit with a tristate enable signal input OEB. The tristate enable signal input OEB is coupled directly to pulldown driver tristate transistors P15, N15 and through inverter I4 to pullup driver tristate transistors P14, N14. CMOS transistors P12,N12,P14,N14 form a NAND gate and CMOS transistors P13,N13,P15,N15 form a NOR gate with inputs V_{IN} and OEB. With the OEB signal low (OE signal high) the tristate output enable circuit does not interfere in the normal operation of the pullup and pulldown predriver circuits. The output pullup and pulldown driver transistors and output V_{OUT} therefore operate in the normal bistate or active mode. With OEB signal high (OE signal low) the output pullup and pulldown transistors P11, N11 are disabled and present a high impedance at the output V_{OUT}.

The rise and fall times for output signal transitions between high and low potential levels at the output V_{OUT} are functions of the size of the respective output pullup and pulldown transistors P11, N11, the speed of switching of the output driver transistors P11, N11 by the respective pullup and pulldown driver circuits, and the size of the load capacitance being charged or discharged at the output V_{OUT}. Typically the edge rates or slew rates of output signals and the rise and fall times at the edges of the output signals are determined primarily by the sizes of the output pullup and pulldown transistors P11, N11 and the sizes of the pullup and pulldown driver stage circuit transistors P12, N12, P13, N13.

A multistage all-CMOS buffer circuit 10 is illustrated Fig. 3. Multiple output buffers of this type may be incorporated, for example, as output buffers in an octal buffer line driver. The pulldown transistor element is provided by the relatively large current carrying capacity NMOS transistor N11. The pullup transistor element is provided by relatively large current carrying capacity PMOS transistor element P11. Output buffer 10 is a non-inverting tristate output device, and data signals propagate from the input V_{IN} to the output V_{OUT}. The tristate output enable and disable signals are applied at the OEB terminal input.

A data signal at the input V_{IN} passes through two current amplification CMOS inverter stages 12, 14 and then is applied at the same polarity as the input to the pullup driver NAND gate 15 and the pulldown driver NOR gate 16. NAND gate 15 drives PMOS pullup transistor element P3. NOR gate 16 drives the NMOS pulldown transistor element N3. The second input to each of the gates 15, 16 is derived from the OEB terminal input.

An output enable signal OEB is applied with inverted polarity OE at the tristate OEB terminal. This tristate signal passes through first and second current amplification CMOS inverter stages 18, 20 and is applied at the same polarity as the OEB signal to the input of pulldown driver NOR gate 16. The tristate signal also passes through first and second CMOS inverter stages 18, 20 and a third inverter stage 22 before it is applied to the input of NAND gate 15. The tristate signal applied to the input of pullup driver NAND gate 15 is thus of opposite polarity from the OEB signal and is in phase with output enable signal OE.

A disadvantage of the pure CMOS output buffer circuits of FIGS. 2 & 3 is the large output capacitance associated with large CMOS output pullup and pulldown transistors P11,N11. As a result steps must be taken to reduce the relatively great switching induced noise at the output V_{OUT} and output power rails, for example as described in the Jeffrey B. Davis U.S. Patents 4,961,010, and 5,036,222; the Alan C. Rogers U.S. Patent No. 5,049,763; and the Jeffrey B. Davis U.S. Patent Application Serial No. 483,927 filed February 22, 1990.

As used in this specification and in the claims, the transistor designation "CMOS" is used generically to include either PMOS or P channel field effect transistors, NMOS or N channel field effect transistors, or both. The reference to CMOS stages in the BICMOS circuits of the present invention refers to one or more CMOS transistors generally in combinations of PMOS and NMOS transistors but also combinations of all PMOS or all NMOS transistors, performing a specified circuit function.

### Objects of the Invention

It is therefore an object of the present invention to provide new BICMOS logic, buffer, and output circuits combining the low power requirements and high speed advantages of CMOS transistors with the low capacitance and high current amplification advantages of bipolar transistors.

This object is addressed by the present invention as defined in the patent claims, particularly in patent claim 1.

Preferably, the present invention provides a new BICMOS circuit having data signal paths defined by CMOS transistors including a relatively high input impedance CMOS input stage. A relatively low output impedance bipolar output stage with current amplification is provided by bipolar output transistors.

Preferably, invention provides a BICMOS output buffer circuit with CMOS data signal paths and bipolar output drive which minimizes simultaneous "crowbar" current between bipolar output pullup and pulldown transistors. The invention may provide a fast DCMK CMOS transistor with switching speed sufficient to function also as an ACMK transistor.

### Disclosure of the Preferred Embodiment

In order to accomplish these results the invention provides a BICMOS output buffer circuit having CMOS transistors and bipolar transistors coupled between high and low potential power rails. The BICMOS output buffer circuit delivers output signals of high and low potential levels at an output in response to data signals propagating through data signal paths of the BICMOS output buffer circuit from a data signal input. The invention provides a bipolar output stage with relatively large current conducting bipolar output pullup and pulldown transistors coupled to the output and providing relatively low output impedance for the BICMOS output buffer circuit.

Data signal paths are coupled to the output stage. The data signal paths are defined by CMOS transistors including a CMOS input stage coupled to the input with relatively small current conducting CMOS transistors affording relatively high input impedance for the BICMOS output buffer circuit. A feature of the BICMOS output buffer circuit is that the bipolar output stage provides current amplification of data signals propagating through data signal paths defined by CMOS transistors.

In the preferred embodiment the BICMOS output buffer circuit includes a first data signal path defined by CMOS transistors including a pullup predriver input stage incorporating P channel and N channel transistors. A second data signal path is defined by CMOS transistors including a pulldown predriver input stage incorporating P channel and N channel CMOS transistors. The pullup predriver input stage CMOS transistors are constructed with the P/N ratio of channel width dimensions skewed relative to the P/N ratio of channel width dimensions of respective pulldown predriver input stage CMOS transistors for skewing the input threshold voltage levels of the respective pullup and pulldown predriver input stages and respective first and second data signal paths. An advantage of the skewed construction according to the invention is that it minimizes simultaneous conduction between the output stage bipolar output pullup and pulldown transistors.

In the case of a non-inverting output buffer circuit, the pulldown predriver input stage CMOS transistors are constructed with the P/N ratio of channel width dimensions substantially smaller than the respective P/N ratio of channel width dimensions of the pulldown predriver input stage CMOS transistors. The input threshold voltage level of the pulldown predriver input stage is therefore relatively lower than the input threshold voltage level of the pullup predriver input stage. The non-inverting BICMOS output buffer circuit provides early turn off of the bipolar output pulldown transistor before turn on of the bipolar output pullup transistor during LH transitions at the input and output. Similarly the circuit provides early turn off of the bipolar output pullup transistor before turn on of the bipolar output pulldown transistor during HL transitions at the input and output.

The second data signal path includes a pulldown driver stage coupled to a base node of the bipolar output pulldown transistor. The pulldown driver stage in turn includes a CMOS pulldown driver transistor having a primary current path coupled for sourcing current to the base node of the bipolar output pulldown transistor from a high potential power rail. The CMOS pulldown driver transistor provides an effective "phase splitter" transistor for operating the bipolar output pulldown transistor out of phase with the bipolar output pullup transistor. A CMOS Miller Killer (MK) transistor is coupled for sinking current from the base node of the bipolar output pulldown transistor to a low potential power rail.

In the case of the non-inverting BICMOS output buffer circuit, the CMOS pulldown driver "phase splitter" transistor is an NMOS transistor having a control gate node coupled to a common node of the pulldown predriver input stage. The CMOS MK transistor is also an NMOS transistor. An MK transistor CMOS predriver stage is coupled between the common node of the pulldown predriver input stage and a control gate node of the CMOS MK transistor.

Advantageously, the CMOS MK transistor and MK transistor CMOS predriver stage are relatively small current conducting CMOS transistors constructed with relatively small channel width dimensions. The small dimensional construction provides fast turn on of the CMOS MK transistor sufficient for operating as an ACMK transistor as well as a DCMK transistor.

Preferably, an accelerating feedback diode is coupled between the output and the primary current path of the CMOS pulldown driver transistor. The accelerating feedback diode accelerates turn on of the bipolar output pulldown transistor through the CMOS pulldown driver transistor during transition from high to low potential level at the output.

### Brief Description of the Drawings

FIG. 1 is a schematic circuit diagram of a prior art BICMOS output buffer circuit.

FIG. 2 is a schematic circuit diagram of a prior art CMOS output buffer circuit.

FIG. 3 is a schematic circuit diagram of a prior art CMOS multistage output buffer circuit.

FIG. 4 is a schematic circuit diagram of a new BICMOS output buffer circuit according to the invention.

### Description of Preferred Example Embodiments and Best Mode of the Invention

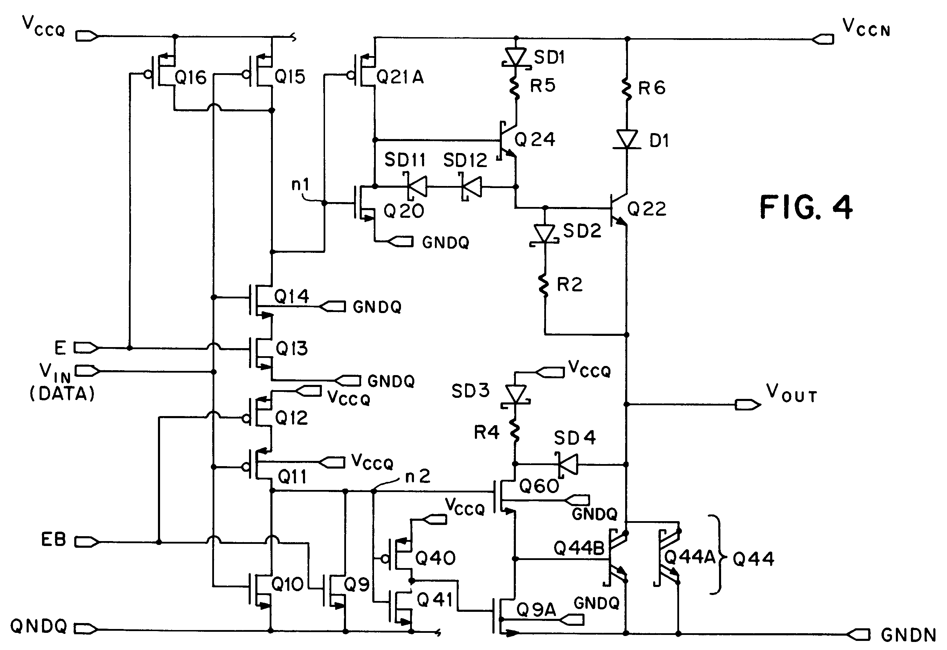

A non-inverting BICMOS tristate output buffer circuit according to the invention is illustrated in FIG. 4. The BICMOS output buffer circuit delivers output signals of high and low potential levels H,L at the output V_{OUT} in response to data signals at the input V_{IN}. Darlington bipolar output pullup transistors Q24,Q22 source current to the output V_{OUT} from the high potential output supply rail V_{CCN} through diode D1 and resistor R6 coupled to the collector node of bipolar output pullup transistor Q22. High current drive bipolar output pulldown transistor Q44 composed of transistor elements Q44A and Q44B sinks current from the output V_{OUT} to the low potential output ground rail GNDN.

On the pullup side of the output buffer circuit a CMOS pullup driver circuit is coupled to the output pullup transistors. The CMOS pullup driver circuit is composed of a first pullup predriver input inverter stage Q15,Q14 coupled to the input V_{IN}, and a second pullup driver inverter stage Q21A,Q20 coupled to the first inverter stage Q15,Q14 at an intermediate node n1. The second inverter stage Q21A,Q20 is coupled to the base nodes of bipolar output pullup transistors Q24,Q22. With a high potential level data signal H at the input V_{IN}, the second pullup driver inverter stage PMOS transistor Q21A provides base drive current to bipolar transistor Q24. Bipolar transistor Q24 in turn sources amplified base drive current from output supply rail V_{CCN} to bipolar output pullup transistor Q22 through Schottky diode SD1 and resistor R5.

For a low potential level data signal L at the input V_{IN}, the second pullup driver inverter stage NMOS transistor Q20 discharges the base of bipolar output pullup transistors Q24,Q22. The discharge path from the base node of output pullup transistor Q22 contains breakdown protection voltage drop components in the form of Schottky diodes SD12 and SD11. Diodes SD11 and SD12 add sufficient voltage difference to prevent breakdown current flow back from the output V_{OUT} through the base/emitter junction of output pullup transistor Q22. This breakdown protection prevents current flow through NMOS transistor Q20 during the high impedance third state at the output. In the tristate mode of operation of the BICMOS output buffer circuit hereafter described, a high potential level signal at the output V_{OUT} from another output buffer circuit on a common bus might otherwise cause breakdown current to flow in a discharge path through Q22 and Q20.

On the pulldown side of the BICMOS output buffer circuit, a first pulldown predriver input inverter stage Q11,Q10 is coupled to the input V_{IN}. A second pulldown driver stage Q60,Q9A is coupled to the base node of the bipolar output pulldown transistor Q44. The pulldown driver stage includes an NMOS pulldown driver transistor Q60 having a control gate node coupled to a common node n2 of the pulldown predriver input stage Q11,Q10. The pulldown driver transistor Q60 is coupled for sourcing current from the high potential level power rail V_{CCQ} through diode SD3 and limiting resistor R4 to the base node of bipolar output pulldown transistor Q44. Transistor Q60 is an effective "phase splitter" operating bipolar output pulldown transistor Q44 out of phase with bipolar output pullup transistor Q22.

The pulldown driver stage also includes a Miller Killer transistor Q9A coupled for sinking parasitic Miller capacitance current from the base node of bipolar pulldown transistor Q44 to the output ground GNDN. A Miller Killer predriver stage Q40,Q41 is coupled between the common node n2 of the pulldown predriver input stage Q11,Q10 and the control gate node of the MK transistor Q9A. The small current conducting MK transistor Q9A and MK predriver stage transistors Q40,Q41 are constructed with small channel width dimensions for fast switching operation. The operation of MK transistor Q9A is sufficiently fast so that it operates as an ACMK during HL transitions at the output V_{OUT} as well as a DCMK transistor after switching during steady state high H at the output V_{OUT}. Example values of relative channel width dimensions for the same channel length dimensions are illustrated in TABLE I.

An accelerating feedback diode SD4 is coupled between the output V_{OUT} and the drain node of pulldown driver transistor Q60. Discharge current from the output V_{OUT} is therefore fed back through the primary current path of NMOS pulldown driver transistor Q60 for accelerating turn on of the bipolar output pulldown transistor Q44 during transition from high to low potential level HL at the output.

The BICMOS output buffer circuit of FIG. 4 also incorporates a tristate enable circuit having complementary tristate enable signal inputs E and EB. A CMOS pullup tristate enable stage Q16,Q13 is coupled in a NAND gate coupling with the pullup predriver input stage Q15,Q14 in the first data signal path. Thus, the PMOS transistors Q16,Q15 are coupled in parallel and the NMOS transistors Q14,Q13 are coupled in series. The NAND gate inputs are the data input V_{IN} and the enable signal input E.

A pulldown tristate enable stage Q12,Q9 is coupled in a NOR gate coupling with the input pulldown predriver stage Q11,Q10 in the second data signal path. Thus, PMOS transistors Q12,Q11 are coupled in series and NMOS transistors Q10,Q9 are coupled in parallel. The NOR gate inputs are the data input V_{IN} and the complementary enable signal input EB.

As shown in TABLE I, the input pullup predriver stage CMOS transistors Q15,Q14 are constructed with the P/N ratio of channel width dimensions skewed in size relative to the P/N ratio of channel width dimensions of the input pulldown predriver stage CMOS transistors Q11, Q10. The word "skewed" is used herein to indicate that the P/N ratio of channel width dimensions depart from conventional comparable, symmetrical or substantially equal ratio values for the corresponding transistors of the respective input stages in the first and second data paths. This skewed construction skews the input threshold voltage levels of the respective pullup and pulldown predriver input stages and respective first and second data signal paths. The skewing of input threshold voltage in turn reduces or minimizes simultaneous conduction crowbar current through the output stage bipolar output pullup Q22 and pulldown Q44 transistors following data signal transitions at the input.

For the non-inverting BICMOS output buffer circuit of FIG. 4 the pulldown driver input stage CMOS transistors Q11,Q10 are constructed with the P/N ratio of channel width dimensions substantially smaller than the P/N ratio of respective channel width dimensions of the pullup predriver input stage CMOS transistors Q15,Q14 for the same channel length. The input threshold voltage level of the input pulldown predriver stage is therefore relatively lower than the input threshold voltage level of the input pullup predriver stage. This skewed arrangement results in early turn off of the bipolar output pulldown transistor Q44 before turn on of the bipolar output pullup transistor Q22 during LH transitions at the input V_{IN} and output V_{OUT}. It also provides early turn off of the bipolar output pullup transistor Q22 before turn on of the bipolar output pulldown transistor Q44 during HL transitions at the input V_{IN} and the output V_{OUT}. Preferably the channel width dimensions are selected and input threshold voltage levels skewed to provide a slight dead time or flat time during transition when neither the bipolar output pullup and pulldown transistors Q22,Q44 are conducting.

The skewed construction at the input is also found in the pullup and pulldown tristate enable stages. As also shown in TABLE I, the CMOS transistors of the tristate enable circuit are also constructed so that the P/N ratio of channel width dimensions of the pullup tristate enable stage CMOS transistors Q16,Q13 are skewed relative to the P/N ratio of channel width dimensions of the pulldown tristate enable stage CMOS transistors Q12,Q9, for the same channel length. The direction of skew conforms with the skewed construction of the pullup and pulldown predriver input stages for skewing the input threshold voltage levels of the respective NAND and NOR gates at the input of the BICMOS output buffer circuit.

In the example of FIG. 4 and TABLE I it is noted that the series coupled NMOS transistors Q14,Q13 of the input NAND gate each have a channel width dimension of 140 microns (µ) for an effective NAND gate pullup channel width dimension of 70µ. Similarly, the series coupled PMOS transistors Q12,Q11 of the input NOR gate each have channel width dimensions of 120µ for an effective NOR gate pulldown channel width of 60µ. For the input NAND gate on the pullup side of the BICMOS output buffer circuit, the ratio of P channel to N channel is therefore 45/70. For the input NOR gate on the pulldown side of the BICMOS output buffer circuit, the ratio of P channel to N channel is 60/335. The skewed P/N ratio values are approximately 1/2 for the pullup NAND gate input stage and 1/5 for the pulldown NOR gate input stage. This construction results in an input threshold voltage level for the input NOR gate, pulldown predriver input stage, and second data path of approximately 1.4v. The input threshold voltage level for the input NAND gate, pullup predriver input stage, and first data path is approximately 1.6v. This skewed construction substantially minimizes the simultaneous conduction crowbar current through the bipolar output stage and provides a dead time or flat time during transition between 1.4v and 1.6v when neither the bipolar pullup or pulldown transistors are conducting.

**TABLE I**

| CMOS TRANSISTOR | CHANNEL WIDTH (µ) |
|---|---|
| Q9A | 20µ |
| Q9 | 60µ |
| Q10 | 335µ |
| Q11 | 120µ |
| Q12 | 120µ |
| Q13 | 140µ |
| Q14 | 140µ |
| Q15 | 45µ |
| Q16 | 64µ |
| Q20 | 10µ |
| Q20A | 20µ |
| Q40 | 20µ |
| Q41 | 10µ |
| Q60 | 175µ |

While the invention has been described with respect to particular example embodiments it is intended to cover all modifications and equivalents within the scope of the following claims.

## Claims

1. A BICMOS output buffer circuit having CMOS transistors and bipolar transistors coupled between high and low potential power rails for delivering output signals of high and low potential levels at an output in response to data signals propagating through data signal paths of the BICMOS output buffer circuit from a data signal input comprising:
a bipolar output stage comprising relatively large current conducting bipolar output pullup and pulldown transistors coupled to the output and providing relatively low output impedance for the BICMOS output buffer circuit;
and data signal paths coupled to the output stage, said data signal paths being defined by CMOS transistors including a CMOS input stage coupled to the input comprising relatively small current conducting CMOS transistors affording relatively high input impedance for the BICMOS output buffer circuit;
said bipolar output stage providing current amplification of data signals from the CMOS transistor defined data signal paths.

2. The BICMOS output buffer circuit of claim 1 comprising a first data signal path defined by CMOS transistors including a pullup predriver input stage incorporating P channel and N channel transistors, and a second data signal path defined by CMOS transistors including a pulldown predriver input stage incorporating P channel and N channel transistors.

3. The BICMOS output buffer circuit of claim 2 wherein the CMOS transistors of the pullup predriver input stage are constructed with the P/N ratio of channel width dimensions skewed relative to the P/N ratio of channel width dimensions of respective CMOS transistors of the pulldown predriver input stage for skewing the input threshold voltage levels of the respective pullup and pulldown predriver input stages and respective first and second data signal paths for minimizing simultaneous conduction between the output stage bipolar output pullup transistor and bipolar output pulldown transistor.

4. The BICMOS output buffer circuit of claim 3 wherein the BICMOS output buffer circuit is a non-inverting output buffer circuit, and wherein the pulldown predriver input stage CMOS transistors are constructed with the P/N ratio of channel width dimensions substantially smaller than the respective P/N ratio of channel width dimensions of the pullup predriver input stage CMOS transistors so that the input threshold voltage level of the pulldown predriver input stage is relatively lower than the input threshold voltage level of the pullup predriver input stage.

5. The BICMOS output buffer circuit of claim 2 wherein the second data signal path comprises a pulldown driver stage coupled to a base node of the bipolar output pulldown transistor, said pulldown driver stage comprising a CMOS pulldown driver transistor having a primary current path coupled for sourcing current to the base node of the bipolar output pulldown transistor from a high potential power rail, and a CMOS Miller Killer (MK) transistor coupled for sinking current from the base node of the bipolar output pulldown transistor to a low potential power rail.

6. The BICMOS output buffer circuit of claim 5 wherein the BICMOS output buffer circuit is a non-inverting output buffer circuit, wherein the CMOS pulldown driver transistor is an NMOS transistor having a control gate node coupled to a common node of the pulldown predriver input stage, wherein the CMOS MK transistor is an NMOS transistor, and comprising a MK transistor CMOS predriver stage coupled between said common node of the pulldown predriver input stage and a control gate node of the CMOS MK transistor.

7. The BICMOS output buffer circuit of claim 5 wherein the CMOS MK transistor and MK transistor CMOS predriver stage comprise relatively small current conducting CMOS transistors being constructed with relatively small channel width dimensions to provide fast turn on of the CMOS MK transistor sufficient for operating as an ACMK transistor as well as a DCMK transistor.

8. The BICMOS output buffer circuit of claim 5 comprising an accelerating feedback diode coupled between the output and the primary current path of the CMOS pulldown driver transistor for accelerating turn on of the bipolar output pulldown transistor during transition from high to low potential at the output.

9. The BICMOS output buffer circuit of claim 2 comprising a CMOS tristate enable circuit with tristate enable signal inputs, a CMOS pullup tristate enable stage having CMOS transistors coupled in a NAND gate coupling with the CMOS transistors of the pullup predriver input stage in the first data path, and a pulldown tristate enable stage having CMOS transistors coupled in a NOR gate coupling with the CMOS transistors of the pulldown predriver input stage in the second data path.

10. The BICMOS output buffer circuit of claim 3 further comprising a CMOS tristate enable circuit with tristate enable signal inputs, a CMOS pullup tristate enable stage having P channel and N channel CMOS transistors coupled in a NAND gate coupling with the CMOS transistors of the pullup predriver input stage in the first data path, and a pulldown tristate enable stage having P channel and N channel CMOS transistors coupled in a NOR gate coupling with the CMOS transistors of the pulldown predriver input stage in the second data path;
said pullup tristate enable stage CMOS transistors being constructed with the P/N ratio of channel width dimensions skewed relative to the P/N ratio of channel width dimensions of the pulldown tristate enable stage CMOS transistors for skewing the input threshold voltage levels of the respective NAND and NOR gates and minimizing simultaneous conduction between the output stage bipolar output pullup transistor and bipolar output pulldown transistor.

11. A BICMOS output buffer circuit for delivering output signals of high and low potential levels at an output in response to data signals propagating through data signal paths from an input, comprising:
an output stage comprising bipolar transistors including a relatively large current conducting bipolar output pullup transistor coupled for sourcing current (through a primary current path) to the output from a high potential power rail;
said output stage comprising a relatively large current conducting bipolar output pulldown transistor coupled for sinking current (through a primary current path) from the output to a low potential power rail;
said output stage bipolar output pullup and pulldown transistors being constructed with internal resistance affording relatively low output impedance for the BICMOS output buffer circuit;
a pullup driver stage comprising CMOS transistors in a first data signal path of the BICMOS output buffer circuit coupled to a base node of the bipolar output pullup transistor;
an input pullup predriver stage comprising relatively small current conducting P channel and N channel CMOS transistors in the first data path having control gate nodes coupled to the input;
a pulldown driver stage comprising CMOS transistors in a second data signal path of the BICMOS output buffer circuit coupled to a base node of the bipolar output pulldown transistor for controlling the conducting state out of phase with the conducting state of the bipolar output pullup transistor;
and an input pulldown predriver stage comprising relatively small current conducting P channel and N channel CMOS transistors in the second data signal path having control gate nodes coupled to the input;
said input pullup predriver stage and input pulldown predriver stage CMOS transistors being constructed with channel width dimensions affording relatively high input impedance for the BICMOS output buffer circuit.

12. The BICMOS output buffer circuit of claim 11 wherein the input pullup predriver stage CMOS transistors are constructed with the P/N ratio of channel width dimensions skewed in size relative to the P/N ratio of channel width dimensions of the input pulldown predriver stage CMOS transistors for skewing the input threshold voltage levels of the respective input pullup and pulldown predriver stages and respective first and second data signal paths for minimizing simultaneous conduction between the output stage bipolar output pullup transistor and bipolar output pulldown transistor following data signal transitions at the input.

13. The BICMOS output buffer circuit of claim 12 wherein the BICMOS output buffer circuit is a non-inverting output buffer circuit and wherein the input pulldown predriver stage CMOS transistors are constructed with the P/N ratio of channel width dimensions substantially smaller than the respective P/N ratio of channel width dimensions of the input pullup predriver stage CMOS transistors so that the input threshold voltage level of the input pulldown predriver stage is relatively lower than the input threshold voltage level of the input pullup predriver stage for early turn off of the bipolar output pulldown transistor before turn on of the bipolar output pullup transistor during LH transitions at the input and output and for early turn off of the bipolar output pullup transistor before turn on of the bipolar output pulldown transistor during HL transitions.

14. The BICMOS output buffer circuit of claim 11 wherein the output pulldown driver stage comprises a CMOS pulldown driver transistor having a primary current path coupled for sourcing current to the base node of the bipolar output pullup transistor from a high potential power rail, said CMOS pulldown driver transistor having a control gate node coupled to a common node of the input pulldown predriver stage CMOS transistors.

15. The BICMOS output buffer circuit of claim 14 wherein the output pulldown driver stage further comprises a CMOS Miller Killer (MK) transistor coupled for sinking current from the base node of the bipolar output pulldown transistor to a low potential power rail, and a MK transistor CMOS predriver stage coupled between said common node of the input pulldown predriver stage and a control gate node of the CMOS MK transistor for control of the CMOS MK transistor in opposite phase from said CMOS pulldown driver transistor.

16. The BICMOS output buffer circuit of claim 15 wherein the BICMOS output buffer circuit is a non-inverting output buffer circuit, wherein the CMOS pulldown driver transistor is an NMOS transistor, and wherein the CMOS MK transistor is an NMOS transistor.

17. The BICMOS output buffer circuit of claim 15 wherein the CMOS MK transistor and MK transistor CMOS predriver stage comprise relatively small current conducting CMOS transistors being constructed with relatively small channel width dimensions to provide fast turn on of the CMOS MK transistor sufficient for operating as an ACMK transistor as well as a DCMK transistor.

18. The BICMOS output buffer circuit of claim 14 further comprising an accelerating feedback diode coupled between the output and the primary current path of the CMOS pulldown driver transistor for accelerating turn on of the bipolar output pulldown transistor during transition from high to low potential at the output.

19. The BICMOS output buffer circuit of claim 11 further comprising a CMOS tristate enable circuit having complementary tristate enable signal inputs and a CMOS pullup tristate enable stage having CMOS transistors coupled in a NAND gate coupling with the CMOS transistors of the input pullup predriver stage in the first data signal path, said CMOS tristate enable circuit further comprising a pulldown tristate enable stage having CMOS transistors coupled in a NOR gate coupling with the CMOS transistors of the input pulldown predriver stage in the second data signal path.

20. BICMOS output buffer circuit of claim 12 further comprising a CMOS tristate enable circuit having complementary tristate enable signal inputs and a CMOS pullup tristate enable stage having P channel and N channel CMOS transistors coupled in a NAND gate coupling with the CMOS transistors of the input pullup predriver stage in the first data signal path, said CMOS tristate enable circuit further comprising a pulldown tristate enable stage having P channel and N channel CMOS transistors coupled in a NOR gate coupling with the CMOS transistors of the input pulldown predriver stage in the second data signal path, said pullup tristate enable stage CMOS transistors being constructed with the P/N ratio of channel width dimensions skewed relative to the P/N ratio of channel width dimensions of the pulldown tristate enable stage CMOS transistors for skewing the input threshold voltage levels of the respective NAND and NOR gates for minimizing simultaneous conduction between the output stage bipolar output pullup transistor and bipolar output pulldown transistor.
